# EUROPEAN PATENT APPLICATION

(11) **EP 2 706 049 A1**
(43) Date of publication of application: **12.03.2014**
(21) Application number: 13182908.7
(22) Date of filing: 04.09.2013
(51) Int. Cl.: C04B 35/472, H01L 21/02

(54) **Composition for forming ferroelectric thin film, method for forming thin film and thin film formed using the same method**

(30) Priority: 11.09.2012 JP 2012199472
(71) Applicant: Mitsubishi Materials Corporation, Chiyoda-ku Tokyo 100-8117 (JP)
(72) Inventor: Fujii, Jun, Ibaraki (JP); Sakurai, Hideaki, Ibaraki. (JP); Soyama, Nobuyuki, Ibaraki. (JP)
(74) Representative: Gille Hrabal

(57) **Abstract**

[Task] Cracking does not occur in a ferroelectric thin film even when Ce is not doped in a composition for forming ferroelectric thin films and a composition for forming relatively thick ferroelectric thin films contains lead acetate instead of lead nitrate.

[Means for Resolution] A ferroelectric thin film made of a titanate lead-based perovskite film or a titanate zirconate lead-based complex perovskite film is formed using the composition for forming ferroelectric thin films. The composition includes lead acetate, a stabilizing agent made of lactic acid and polyvinyl pyrrolidone. In addition, a monomer-equivalent molar ratio of polyvinyl pyrrolidone to a perovskite A site atom included in the composition is more than 0 to less than 0.015. Furthermore, a weight average molecular weight of the polyvinyl pyrrolidone is 5000 to 100000.

## Description

### [Technical Field]

The present invention relates to a composition for forming ferroelectric thin films which is suitable for use of thin film capacitors having a high capacitance and a high density and the like, a method for forming ferroelectric thin films, and a ferroelectric thin film formed using the same method.

### [Background Art]

In the past, methods for manufacturing thin film ferroelectric bodies in which a precursor solution for forming a dielectric body obtained by dissolving a precursor for forming a dielectric body selected from lead titanate (PT), lead-zirconate-titanate (PZT) and the like in an organic solvent mainly including at least one selected from lower alcohols, β-diketones and the like is coated and dried on a metal substrate so as to form a coated film of the precursor for forming a dielectric body; the coated film is calcined at a temperature in a range of a decomposition temperature of organic substances in the coated film to a crystallization temperature of the dielectric body; the precursor solution for forming a dielectric body is repeatedly coated, dried, calcined, and then fired at the crystallization temperature of the dielectric body or higher or the precursor solution for forming a dielectric body is repeatedly coated, dried on a metal plate, and fired at the crystallization temperature of the dielectric body or higher, thereby forming two or more layers of thin films of lead titanate (PT), lead-zirconate-titanate (PZT) and the like on the metal substrate were disclosed (for example, refer to Patent Document 1). In the methods for manufacturing thin film ferroelectric bodies which are configured as described above, it is possible to form a crystallized dielectric body thin film that has a desired film thickness, does not allow electric currents to flow and, furthermore, exhibits ferroelectricity on a metal substrate.

In addition, a method for forming ferroelectric films in which hydrated fatty acid lead is diluted using an alcohol solvent and then boiled so as to generate fatty acid lead from which crystallization water is removed, subsequently, a titanium alkoxide which is a raw material is diluted using an alcohol solvent and then boiled at a boiling point of an alcohol which is a component of the titanium alkoxide or higher so as to generate a titanium alkoxide through alcohol exchange, subsequently, a zirconium alkoxide which is a raw material is diluted using an alcohol solvent and then boiled at a boiling point of an alcohol which is a component of the zirconium alkoxide or higher so as to generate a zirconium alkoxide through alcohol exchange, furthermore, the fatty acid lead from which crystallization water is removed, the alcohol-exchanged titanium alkoxide and the alcohol-exchanged zirconium alkoxide are boiled at a boiling temperature or higher of an ester of an alcohol in the alcohol solvent and a fatty acid which is a component of the fatty acid lead, thereby generating a lead titanium double alkoxide and a lead zirconium double alkoxide is disclosed (for example, refer to Patent Document 2). In the method for forming ferroelectric films, after the lead titanium double alkoxide and the lead zirconium alkoxide are generated, a reaction product thereof is cooled at room temperature, a concentration is adjusted by adding an alcohol solvent, furthermore, the reaction product is hydrolyzed by adding and stirring water, and the reaction product is polymerized through a condensation reaction. In addition, a fourth metal element such as lanthanum, niobium or iron is added. Furthermore, after a raw material solution is prepared by polymerizing the reaction product, the raw material solution is coated, the coated raw material solution is dried so as to form a dried film, and the dried film is sintered, thereby producing a ferroelectric film.

Since the method for forming ferroelectric films which is configured as described above includes Step (a) in which fatty acid lead is obtained when a ferroelectric film made of lead zirconate titanate is formed using a sol-gel method, Step (b) in which a titanium alkoxide is obtained, Step (c) in which a zirconium alkoxide having the same alcohol residue as the titanium alkoxide is obtained, and Step (d) in which the fatty acid lead, the titanium alkoxide and the zirconium alkoxide are mixed so as to generate a lead titanium double alkoxide and a lead zirconium double alkoxide, alcohol residues of the double alkoxides generated in Step (d) become the same, whereby the subsequent hydrolysis and condensation reaction uniformly (no substantial difference between the respective double alkoxides) proceed. As a result, alcohol residues in a macromolecular compound of an obtained metallic oxide also become the same, molecular structures become uniform (no composition deviation), only small kinds of byproducts are generated, and can be easily removed. Therefore, it is possible to relieve intermolecular stresses caused by the composition deviation of the obtained macromolecular compound or decomposition of organic groups and to reduce a density of defects such as pores, and PZT thin films formed using the sol-gel solution have flat surfaces, have favorable electrical characteristics such as large residual polarization and small leakage current, and can satisfy required performance.

However, in the method for manufacturing thin film ferroelectric bodies described in Patent Document 1 of the related art and the method for forming ferroelectric films described in Patent Document 2 of the related art, since a thin film ferroelectric body or a ferroelectric film was attached to a substrate, a large stress was caused, and there was a problem in that it was not possible to increase the relative permittivity of the thin film ferroelectric body or the ferroelectric film due to the stress.

Non Patent Document 1 and Patent Document 3 disclose efforts to solve the above problem. In a research paper of Non Patent Document 1 regarding the effect of cerium doping on a micro-structure and the electrical properties of a PZT thin film obtained using a sol-gel method, it is disclosed that doping of a maximum of 1 atomic% of Ce improves the insulation characteristics and ferroelectric characteristics of PZT thin films, and optimal doping of Ce is effective for reducing the leakage current density and increasing the dielectric breakdown strength of PZT thin films. The paper describes that, in Ce-doped PZT thin films, the dielectric constant is increased by doping 1 atomic% of Ce, the dielectric dissipation factor is almost constant until 1 atomic% of Ce is doped, and, when more than 1 atomic% of Ce is doped, the dielectric constant decreases, and the dielectric loss increases.

Meanwhile, Patent Document 3 discloses a method for forming titanate zirconate lead-based complex perovskite films using a sol-gel method in which a sol includes lead nitrate and acetyl acetone, and a gel film obtained by converting the sol into a gel is fired. In the method for forming complex perovskite films, a molar number of acetyl acetone is 0.25 times to 40 times a molar number of a perovskite A site atom included in the sol. In addition, the gel film includes a hydrophilic macromolecule having a pyrrolidone group. Furthermore, the sol (coating fluid) is prepared in the following manner. First, lead nitrate is added to an alcohol solvent such as 2-methoxy ethanol, after the lead nitrate is dissolved, a hydrophilic polymer having a pyrrolidone group such as polyvinyl pyrrolidone is added and dissolved. Next, a zirconium alkoxide such as zirconium tetra normal propoxide, an alcohol such as 1-propanol and a titanium alkoxide such as titanium tetra isopropoxide are added while adding and stirring acetyl acetone, and, as necessary, stirred while being heated to, for example, 70°C. In addition, a solution is cooled to room temperature and left to stand. Thereby, the sol (coating fluid) is prepared.

In a method for forming titanate zirconate lead-based complex perovskite films in which a sol includes lead acetate trihydrate and acetyl acetone, cracking occurs in a thick complex perovskite film, however, in a method for forming titanate zirconate lead-based complex perovskite films in which a sol includes lead nitrate and acetyl acetone, it is possible to form thick complex perovskite films without causing cracking. In addition, since the molar number of acetyl acetone is 0.25 times to 40 times the molar number of the perovskite A site atom included in the sol, it is possible to form thicker complex perovskite films without causing cracking. Furthermore, since the gel film includes the hydrophilic macromolecule having a pyrrolidone group, it becomes possible to form further thicker complex perovskite films without causing cracking.

### [Related art document]

### [Patent Document]

[Patent Document 1] Japanese Unexamined Patent Document Publication No. 60-236404 (Claim 1, Rows 14 to 16 in the left column on Page 5 of the specification)
[Patent Document 2] Japanese Unexamined Patent Document Publication No. 7-252664 (Claims 2, 3, 7 and 8, Paragraphs [0117] and [0118])
[Patent Document 3] Japanese Unexamined Patent Document Publication No. 2002-293623 (Claims 1 to 3, Paragraphs [0006] and [0013], Table 1 in Paragraph [0021])

### [Non Patent Document]

[Non Patent Document 1] S.B.Majumder, D.C.Agrawal, Y.N.Mohapatra and R.S.Katiyar, "Effect of cerium doping on the micro-structure and electrical properties of sol-gel derived Pb1.05(Zr0.53-δCeδTi0.47)03 (δ≤10at.%) thin films", Materials Science and Engineering, B98, (2003), pp. 25 to 32 (Summary on Page 25, Fig. 2 on Page 27, Rows 4 to 8 in "3.2 Electrical Properties" in the left column on Page 28)

### [Disclosure of the Invention]

### [Problem that the Invention is to Solve]

However, in the research paper of Non Patent Document 1 of the related art, it was necessary to dope a maximum of 1 atomic% of Ce in the PZT thin film in order to improve the insulation characteristics and ferroelectric characteristics of PZT thin films and reduce the leakage current density, and there was a disadvantage of an increase in man-hours for producing PZT thin films. In addition, in the method for forming titanate zirconate lead-based complex perovskite films described in Patent Document 3 of the related art, when the sol included lead acetate instead of lead nitrate, in a case in which complex perovskite films were thick, there was a problem of cracking occurring in the films.

An object of the invention is to provide a composition for forming ferroelectric thin films which does not allow cracking to occur even when Ce is not doped in a composition for forming ferroelectric thin films and a composition for forming relatively thick ferroelectric thin films contains lead acetate instead of lead nitrate, a method for forming thin films and a thin film formed using the above method. Another object of the invention is to provide a composition for forming ferroelectric thin films which can be used to produce thin film capacitors having a high capacitance and a high density and other complex electronic components, a method for forming thin films and a thin film formed using the above method.

### [Means for Solving Problem]

A first aspect of the invention is a composition for forming ferroelectric thin films which is to form ferroelectric thin films made of a titanate lead-based perovskite film or a titanate zirconate lead-based complex perovskite film, including lead acetate, a stabilizing agent made of lactic acid and polyvinyl pyrrolidone, in which a monomer-equivalent molar ratio of polyvinyl pyrrolidone to a perovskite A site atom included in the composition is more than 0 to less than 0.015, and a weight average molecular weight of the polyvinyl pyrrolidone is 5000 to 100000.

A second aspect of the invention is an invention based on the first aspect, in which the titanate lead-based perovskite film or the titanate zirconate lead-based complex perovskite film is represented by a formula [(PbₓLa_{y})(Zr_{z}Ti_{(1-z)})O₃]. In the formula, 0.9<x<1.3, 0≤y<0.1, 0≤z<0.9.

A third aspect of the invention is an invention based on the first aspect, in which a raw material for configuring the titanate lead-based perovskite film or the titanate zirconate lead-based complex perovskite film is a compound in which an organic group is bonded with a metal element through an oxygen atom or a nitrogen atom.

A fourth aspect of the invention is an invention based on the third aspect, in which the raw material for configuring the titanate lead-based perovskite film or the titanate zirconate lead-based complex perovskite film is one or two or more selected from a group consisting of organic acid salts, metal alkoxides, metal β-diketonate complexes, metal β-diketone ester complexes, metal β-iminoketo complexes and metal amino complexes.

A fifth aspect of the invention is an invention based on any one of the first to fourth aspects, in which the stabilizing agent is further included in a fraction of 0.2 mole to 3 mole in 1 mole of a total amount of metals in the composition.

A sixth aspect of the invention is an invention based on the first aspect, in which the monomer-equivalent molar ratio of polyvinyl pyrrolidone to the perovskite A site atom included in the composition is 0.001 to 0.01.

A seventh aspect of the invention is a method for forming ferroelectric thin films including a coating step in which the composition for forming ferroelectric thin films according to any one of the first to sixth aspects is coated on a substrate so as to form a coated film, a drying step in which the coated film formed on the substrate is heated in air, an oxidizing atmosphere or a water vapor-containing atmosphere so as to be dried, and a firing step in which the coated film is fired at a crystallization temperature or higher in O₂, N₂, Ar, N₂O, H₂, a gas mixture thereof, dried air or the above atmosphere including water vapor from middle of or after completion of the drying step.

An eighth aspect of the invention is a method for forming ferroelectric thin films including a coating step in which the composition for forming ferroelectric thin films according to any one of the first to sixth aspects is coated on a substrate so as to form a coated film, a drying step in which the coated film formed on the substrate is heated in air, an oxidizing atmosphere or a water vapor-containing atmosphere so as to be dried, a repeating step in which the coating step and the drying step are repeated plural times, and a firing step in which the coated film is fired at a crystallization temperature or higher in O₂, N₂, Ar, N₂O, H₂, a gas mixture thereof, dried air or the above atmosphere including water vapor from middle of or after completion of a final drying step in the repeating step.

A ninth aspect of the invention is a ferroelectric thin film formed using the method according to the seventh or eighth aspect.

A tenth aspect of the invention is a complex electronic component made up of any of thin film capacitors, capacitors, IPDs, DRAM memory capacitors, multi-layer capacitors, gate insulators of transistors, non-volatile memories, pyroelectric infrared detection elements, piezoelectric elements, electrooptic elements, actuators, resonators, ultrasonic motors, surface acoustic wave elements, transducers and LC noise filter elements which have the ferroelectric thin film according to the ninth aspect.

An eleventh aspect of the invention is a complex electronic component made up of any of thin film capacitors, capacitors, IPDs, DRAM memory capacitors, multi-layer capacitors, gate insulators of transistors, non-volatile memories, pyroelectric infrared detection elements, piezoelectric elements, electrooptic elements, actuators, resonators, ultrasonic motors, surface acoustic wave elements, transducers and LC noise filter elements which have a ferroelectric thin film that is the ferroelectric thin film according to the ninth aspect and corresponds to a frequency band of 100 MHz or more.

### [Advantage of the Invention]

Since the composition for forming ferroelectric thin films of the first aspect of the invention includes lead acetate, a stabilizing agent made of lactic acid and polyvinyl pyrrolidone, the monomer-equivalent molar ratio of polyvinyl pyrrolidone to a perovskite A site atom included in the composition is more than 0 to less than 0.015, and a weight average molecular weight of the polyvinyl pyrrolidone is 5000 to 100000, cracking does not occur in ferroelectric thin films even when Ce is not doped in the composition for forming ferroelectric thin films and a composition for forming relatively thick ferroelectric thin films contains lead acetate instead of lead nitrate. In addition, when, for example, ferroelectric thin films of thin film capacitors are produced using the composition for forming ferroelectric thin films, it is possible to obtain thin film capacitors having a high capacitance and a high density.

In the composition for forming ferroelectric thin films of the third aspect of the invention, since the raw material for configuring the titanate lead-based perovskite film or the titanate zirconate lead-based complex perovskite film is a compound in which an organic group is bonded with a metal element through an oxygen atom or a nitrogen atom, different kinds of metal elements included in the composition are crosslinked through the oxygen atom or the nitrogen atom. As a result, storage stability of the composition becomes more favorable compared to a case in which the metal elements are simply mixed. In addition, it is possible to decrease the crystallization temperature in the firing step of the composition, and it is possible to enhance composition uniformity of fired thin films.

In the composition for forming ferroelectric thin films of the fifth aspect of the invention, since the stabilizing agent is further included in a fraction of 0.2 mole to 3 mole in 1 mole of the total amount of metals in the composition, the storage stability of the composition becomes favorable, and a hydrolysis reaction in the air is suppressed, and therefore the composition can be easily handled in the air.

In the method for forming ferroelectric thin films of the seventh aspect of the invention, since the composition for forming ferroelectric thin films is coated on a substrate so as to form a coated film, the coated film is heated in the air or the like so as to be dried, and, furthermore, the coated film is fired at a crystallization temperature or higher from the middle of or after completion of the drying step, it is possible to easily form ferroelectric thin films on the substrate without causing cracking.

In the method for forming ferroelectric thin films of the eighth aspect of the invention, since the composition for forming ferroelectric thin films is coated on a substrate so as to form a coated film, the coated film is heated in the air or the like so as to be dried, the coating step and the drying step are repeated plural times, and, furthermore, the coated film is fired at a crystallization temperature or higher from the middle of or after completion of the final drying step in the repeating step, it is possible to relatively easily form thick ferroelectric thin films on the substrate without causing cracking.

### [Best Mode for Carrying Out the Invention]

Next, embodiments for carrying out the invention will be described. A composition for forming ferroelectric thin films of the invention includes lead acetate, a stabilizing agent made of lactic acid and polyvinyl pyrrolidone. The composition is used to form ferroelectric thin films made of a titanate lead-based perovskite film or a titanate zirconate lead-based complex perovskite film. In addition, a monomer-equivalent molar ratio of polyvinyl pyrrolidone to a perovskite A site atom included in the composition is more than 0 to less than 0.015, and preferably 0.001 to 0.01. Furthermore, a weight average molecular weight of the polyvinyl pyrrolidone included in the composition is 5000 to 100000, and preferably 10000 to 50000. Here, the reason for limiting the monomer-equivalent molar ratio of polyvinyl pyrrolidone to the perovskite A site atom in a range of more than 0 to less than 0.015 is that, when the molar ratio is 0, an effect for increasing electrostatic capacitance of a fired thin film which is considered to be an effect obtained from addition of the polyvinyl pyrrolidone is not obtained, and, when the molar ratio is 0.015 or more, the fired thin film becomes porous, and the electrostatic capacitance decreases. In addition, the reason for limiting the weight average molecular weight of the polyvinyl pyrrolidone in a range of 5000 to 100000 is that, when the weight average molecular weight is less than 5000, the effect for increasing the electrostatic capacitance of a fired thin film is not obtained, and, when the weight average molecular weight exceeds 100000, the fired thin film becomes porous, and the electrostatic capacitance decreases. Meanwhile, the polyvinyl pyrrolidone is a hydrophilic polymer having a pyrrolidone group.

Meanwhile, examples of the titanate lead-based perovskite film include PT [PbTiO₃] film, and examples of the titanate zirconate lead-based complex perovskite film include PZT [Pb(Zr, Ti)O₃] film, PLZT [(Pb, La)(Zr, Ti)O₃] film and the like. That is, the titanate lead-based perovskite film or the titanate zirconate lead-based complex perovskite film is represented by a formula [(PbₓLa_{y})(Zr_{z}Ti_{(1-z)})O_{3]}. In the formula, 0.9<x<1.3, 0≤y<0.1, 0≤z<0.9. In the formula, the film is PLZT in a case in which y≠0 and z≠0, the film is PZT in a case in which y=0 and z≠0, and the film is PT in a case in which y=0 and z=0. Here, the reason for limiting x in the formula in a range of 0.9<x<1.3 is that, when x is 0.9 or less, a pyrochlore phase appears in the fired thin film and the electrostatic capacitance significantly decreases, and, when x exceeds 1.3, an excessive amount of lead appears in a form of lead oxide in the fired thin film, and the electrostatic capacitance significantly decreases. In addition, the reason for limiting y in the formula in a range of 0≤y<0.1 is that, when Y exceeds 0.1, the electrostatic capacitance of the fired thin film decreases. Furthermore, the reason for limiting z in the formula in a range of 0≤z<0.9 is that, when z exceeds 0.9, the electrostatic capacitance of the fired thin film decreases.

Meanwhile, the raw material for configuring the titanate lead-based perovskite film or the titanate zirconate lead-based complex perovskite film is preferably a compound in which an organic group is bonded with a metal element through an oxygen atom or a nitrogen atom. This is because different kinds of metal elements included in the composition are crosslinked through the oxygen atom or the nitrogen atom, and therefore the storage stability of the composition becomes more favorable compared to a case in which the metal elements are simply mixed, also, it is possible to decrease the crystallization temperature in the firing step of the composition, and it is possible to enhance composition uniformity of fired thin films. Examples of the raw material include one or two or more selected from a group consisting of organic acid salts, metal alkoxides, metal β-diketonate complexes, metal β-diketone ester complexes, metal β-iminoketo complexes and metal amino complexes. A particularly preferable compound is an organic acid salt.

Among the above, examples of Pb compounds (Pb sources) include organic acid salts such as acetate salts (lead acetate). In addition, examples of La compounds (la sources) include acetate salts (lanthanum acetate), propionate salts (lanthanum propionate), butyrate (lanthanum butyrate), octoate salts (lanthanum octoate) and primary carboxylates (lanthanum carboxylate); metal alkoxides such as lanthanum triisopropoxide, lanthanum tributoxide (lanthanum tetra n-butoxide, lanthanum tetra i-butoxide and lanthanum tetra t-butoxide), lanthanum alkoxide coordinated with a monovalent alcohol, lanthanum methoxy ethoxide, lanthanum ethoxy ethoxide and lanthanum alkoxy alkoxide; and metal β-diketonate complexes such as lanthanum acetyl acetonate, lanthanum heptafluoro butanoyl pivaloylmethanate, lanthanum dipivaloylmethanate, lanthanum trifluoro acetyl acetonate and lanthanum benzoyl acetonate.

Examples of Ti compounds (Ti sources) include Ti alkoxides coordinated with a monovalent alcohol such as Ti tetra ethoxide, Ti tetra isopropoxide (hereinafter referred to as Ti isopropoxides), Ti tetrabutoxides (Ti tetra n-butoxide, Ti tetra i-butoxide, Ti tetra t-butoxide) and Ti dimethoxy diisopropoxide; metal alkoxides such as Ti methoxy ethoxide, Ti ethoxy ethoxide and Ti alkoxy alkoxide; and metal β-diketonate complexes such as Ti acetyl acetonate, Ti heptafluoro butanoyl pivaloylmethanate, Ti dipivaloylmethanate, Ti trifluoro acetyl acetonate and Ti benzoyl acetonate.

Examples of Zr compounds (Zr sources) include Zr alkoxides coordinated with a monovalent alcohol such as Zr tetra ethoxide, Zr tetra isopropoxide, Zr tetrabutoxides (Zr tetra n-butoxide, Zr tetra i-butoxide, Zr tetra t-butoxide) and Zr dimethoxy diisopropoxide; metal alkoxides such as Zr methoxy ethoxide, Zr ethoxy ethoxide and Zr alkoxy alkoxide; and metal β-diketonate complexes such as Zr acetyl acetonate, Zr heptafluoro butanoyl pivaloylmethanate, Zr dipivaloylmethanate, Zr trifluoro acetyl acetonate and Zr benzoyl acetonate. Meanwhile, the metal alkoxides may be used as they are, or partial hydrolysates thereof may be used in order to accelerate decomposition.

A method for preparing the composition configured as described above will be described. For example, in order to prepare a composition for forming PLZT films, first, a Zr compound (Zr source), a Ti compound (Ti source) and a stabilizing agent are put into a reaction container, and refluxed in an inert gas atmosphere, such as nitrogen gas, at 80°C to 200°C. The stabilizing agent is included in a fraction of preferably 0.2 mole to 3 mole and more preferably 1 mole to 2 mole in 1 mole of a total amount of metals in the composition. That is, the stabilizing agent is included so that (the number of molecules in the stabilizing agent)/(the number of atoms in the metal) preferably becomes 0.2 to 3, and more preferably becomes 1 to 2. Here, the reason for limiting the mixing fraction of the stabilizing agent in 1 mole of the total amount of metals in the composition in a range of 0.2 mole to 3 mole is that, when the mixing fraction is less than 0.2 mole, since the composition is not sufficiently stabilized, the storage stability of the composition deteriorates such that the composition gelates or precipitates are easily formed, and, when the mixing fraction exceeds 3 mole, film-forming properties or the electric properties of thin films deteriorate.

Next, a Pb compound (Pb source) and a La compound (La source) are added to the organic metal compounds, a solvent is added, and the components are refluxed in an inert gas atmosphere, such as nitrogen gas, at 80°C to 200°C. The organic metal compound solution is distilled under reduced pressure at 80°C to 200°C so as to remove byproducts, and then a solvent is further added to the solution so as to adjust a concentration, thereby obtaining a solution containing a predetermined concentration of the metal compounds in terms of an oxide. The solvent is appropriately determined depending on raw materials being used, and general examples that can be used include carboxylic acids, alcohols, esters, ketones (for example, acetone and methyl ethyl ketone), ethers (for examples, dimethyl ether and diethyl ether), cycloalkanes (for example, cyclohexane and cyclohaxanol), aromatic solvents (for example, benzene, toluene and xylene), other tetrahydrofuran and solvent mixtures of two or more of the above. Among the above, propylene glycol is particularly preferable.

Specific examples of the carboxylic acids that are preferably used include n-butyrate, α-methyl butyrate, i-valerate, 2-ethyl butyrate, 2,2-dimetyl butyrate, 3,3-dimethyl butyrate, 2,3-dimethyl butyrate, 3-methyl pentanoate, 4-methyl pentanoate, 2-ethyl pentanoate, 3-ethyl pentanoate, 2,2-dimethyl pentanoate, 3,3-dimethyl pentanoate, 2,3-dimethyl pentanoate, 2-ethyl hexanoate and 3-ethyl hexanoate. In addition, examples of the esters that are preferably used include ethyl acetate, propyl acetate, n-butyl acetate, sec-butyl acetate, tert-butyl acetate, isobutyl acetate, n-amyl acetate, sec-amyl acetate, tert-amyl acetate, and isoamyl acetate; and examples of the alcohols that are preferably used include 1-propanol, 2-propanol, 1-butanol, 2-butanol, isobutyl alcohol, 1-pentanol, 2-pentanol, 2-methyl-2-pentanol and 2-methoxy ethanol.

Next, a diluted alcohol is added to the organic metal compound solution, thereby obtaining a composition containing a predetermined concentration of the metal compounds in terms of an oxide in which a ratio of respective metals (Pb/La/Zr/Ti) becomes a predetermined ratio. Furthermore, polyvinyl pyrrolidone (PVP) is added to the composition so that a monomer-equivalent ratio becomes more than 0 mole% to less than 1.5 mole% and preferably becomes 0.1 mole% to 1.0 mole% in 100 mole% of PLZT molecules. That is, PVP is added to the composition so that the monomer-equivalent mole ratio of PVT to the PLZT molecules becomes more than 0 to less than 0.015 and preferably becomes 0.001 to 0.1. Here, 100 mole% of the PLZT molecules are equivalent to 100 mole% of A-site atoms in PLZT. In addition, a weight average molecular weight of the PVP is 5000 to 100000, and preferably 10000 to 50000. Furthermore, a total concentration of the organic metal compounds in the organic metal compound solution in the composition is preferably set to approximately 0.1 mass% to 20 mass% in terms of the amount of metal oxides.

Meanwhile, in order to remove particles of byproducts from the composition, it is preferable to reduce the number of particles having a particle diameter of 0.5 µm or more (particularly, 0.3 µm, and more particularly 0.2 µm) to 50 particles or less per milliliter of the solution by carrying out a filtration treatment on the composition. When the number of particles having a particle diameter of 0.5 µm or more in the organic metal compound solution exceeds 50 particles/milliliter, the long-term storage stability deteriorates. The number of particles having a particle diameter of 0.5 µm or more in the organic metal compound solution is preferably smaller, and is particularly preferably 30 particles or less per milliliter. A method for treating the organic metal compound solution so as to obtain the above number of the particles is not particularly limited, and examples thereof include the following three methods. A first method is a filtration method in which a commercially available membrane filter having a pore diameter of 0.2 µm is used, and the composition is pressure-fed using a syringe, a second method is a pressure filtration method in which a commercially available membrane filter having a pore diameter of 0.05 µm and a pressurized tank are combined, and a third method is a cycle filtration method in which the filter used in the second method and a solution cycling tank are combined. In all of the methods, particle-trapping rates of filters vary depending on pressures that pressure-feed the solution. It is generally known that the trapping rate increases as the pressure decreases, and, particularly, in the first and second methods, in order to realize a condition in which the number of particles having a particle diameter of 0.5 µm or more is set to 50 particles or less per milliliter, it is preferable to extremely slowly pass the solution through a filter at a low pressure.

A method for forming ferroelectric thin films in which a composition for forming ferroelectric thin films prepared as described above is used will be described. First, the composition for forming ferroelectric thin films is coated on a substrate so as to form a coated film (Coating step). Examples of a method for coating the composition on the substrate include a spin coating method, dip coating, a liquid source misted chemical deposition (LSMCD) method and the like. In addition, a heat-resistant substrate is used as the substrate. Specific examples of the heat-resistant substrate include a substrate having a single-crystal Si layer laminated on a base material such as a Si base material, a substrate having a polycrystalline Si layer laminated thereon, a substrate having a Pt layer laminated thereon, a substrate having a Ti layer and a Pt layer (top layer) laminated thereon in this order, a substrate having a SiO₂ layer, a TiO₂ layer and a Pt layer (top layer) laminated thereon in this order, a substrate having a Ta layer and a Pt layer (top layer) laminated thereon in this order, a substrate having an Ru layer laminated thereon, a substrate having an RuO₂ layer laminated thereon, a substrate having an RuO₂ layer and an Ru layer (top layer) laminated thereon in this order, a substrate having an Ru layer and an RuO₂ layer (top layer) laminated thereon in this order, a substrate having an Ir layer laminated thereon in this order, a substrate having an IrO₂ layer laminated thereon, a substrate having an IrO₂ layer and an Ir layer (top layer) laminated thereon in this order, a substrate having an Ir layer and a Pt layer (top layer) laminated thereon in this order, a substrate having an IrO₂ layer and a Pt layer (top layer) laminated thereon in this order and a substrate having a perovskite-type conductive oxide, such as a SrRuO₃ layer or a (LaₓSr₍₁₋ₓ₎)CoO₃ layer, and the like laminated thereon, but is not limited thereto.

Next, the coated film formed on the substrate is heated to a temperature lower than the crystallization temperature of the coated film in a predetermined atmosphere so as to be dried (preliminary firing) (drying step). Furthermore, from the middle of or after the drying step, the coated film is held in a predetermined atmosphere at the crystallization temperature of the coated film or higher so as to be fired (principal firing) (firing step). Here, in order to form a thick coated film, the coating step and the drying step are preferably repeated plural times (repeating step). In addition, the coated film is fired at the crystallization temperature or higher from the middle of or after completion of a final drying step in the repeating step (firing step). Thereby, a ferroelectric thin film as thick as approximately 50 nm to 1000 nm can be formed.

In addition, since drying (preliminary firing) is carried out in order to remove the solvent and to convert the organic metal compound to titanate lead-based perovskite or titanate zirconate lead-based complex perovskite through thermal decomposition or hydrolysis, the drying is carried out in the air, an oxidizing atmosphere or a water vapor-containing atmosphere. Even in the case of heating in the air, moisture necessary for the hydrolysis is sufficiently ensured from moisture in the air. The heating may be carried out in two steps of low-temperature heating for removing the solvent and high-temperature heating for decomposing the organic metal compounds. In addition, the firing (principal firing) is a step for crystallizing the thin film obtained through drying (preliminary firing) through firing at a temperature of the crystallization temperature or higher, which enables to obtain ferroelectric thin films. The firing step is preferably carried out in O₂, N₂, Ar, N₂O, H₂, a gas mixture thereof, dried air or the above atmosphere including water vapor. Furthermore, the drying (preliminary firing) is carried out at 150°C to 550°C for approximately 5 minutes to 10 minutes, and the firing (principal firing) is carried out at 450°C to 800°C for approximately 1 minute to 60 minutes. The firing (principal firing) may be carried out using a rapid thermal annealing (RTA) treatment. In a case in which the coated film is fired (principal firing) using the RTA treatment, a temperature-increase rate is preferably 10°C/second to 100°C/second.

In ferroelectric thin films manufactured as described above, even when Ce is not doped in the composition for forming the ferroelectric thin films, and a composition for forming relatively thick ferroelectric thin films contains lead acetate instead of lead nitrate, cracking does not occur in the ferroelectric thin films. In addition, for example, when a ferroelectric thin film for thin film capacitors is produced using the composition, it is possible to obtain thin film capacitors having a high capacitance and a high density. In addition, the ferroelectric thin film can be used as a constituent material of complex electronic components such as thin film capacitors, capacitors, Integrated Passive Devices (IPDs), DRAM memory capacitors, multi-layer capacitors, gate insulators of transistors, non-volatile memories, pyroelectric infrared detection elements, piezoelectric elements, electrooptic elements, actuators, resonators, ultrasonic motors, surface acoustic wave elements, transducers and LC noise filter elements. Specifically, the ferroelectric thin film is used in dielectric layers between electrodes in thin film capacitors, dielectric layers in capacitors, dielectric units in IPDs, dielectric layers in DRAM memory capacitors, dielectric layers in multi-layer capacitors, gate insulators of transistors, dielectric layers in non-volatile memories, pyroelectric layers in pyroelectric infrared detection elements, piezoelectric layers in piezoelectric elements, ferroelectric layers in electrooptic elements, piezoelectric layers in actuators, piezoelectric layers in resonators, piezoelectric layers in ultrasonic motors, piezoelectric layers in surface acoustic wave elements, piezoelectric layers in transducers and capacitor units in LC noise filter elements. Furthermore, among the above, it is also possible to use the ferroelectric thin films in, particularly, complex electronic components having a frequency band of 100 MHz or higher.

### [Examples]

Next, Examples of the invention will be described in detail together with Comparative Examples.

### <Example 1>

First, Zr tetra n-butoxide (Zr source), Ti isopropoxide (Ti source) and lactic acid (stabilizing agent) were put into a reaction container, and refluxed in a nitrogen atmosphere. Next, lead acetate trihydrate (Pb source) and lanthanum acetate 1.5 hydrate (La source) were added to the compound, propylene alcohol (solvent) was added, the components were refluxed in a nitrogen atmosphere, distilled under reduced pressure so as to remove byproducts, and then a diluted alcohol was added to the solution, thereby obtaining Composition 1 containing a concentration of 10 mass% of metal compounds in terms of an oxide in which a ratio of respective metals (Pb/La/Zr/Ti) became 125/3/52/48. Here, a mixing fraction of the lactic acid (stabilizing agent) is 2 mole in 1 mole of a total amount of metals in the composition. Polyvinyl pyrrolidone (weight average molecular weight: 5000) was added to Composition 1 in an outer percentage of 0.1 mole% (monomer-equivalent) with respect to 100 mole% of PLZT molecules included in Composition 1, furthermore, particles of byproducts were removed, Composition 1 was coated on a substrate using a spin coating method so as to form a coated film, and then the coated film on the substrate was heated at 350°C (a temperature lower than the crystallization temperature of the coated film) in the air so as to be dried. Here, 100 mole% of the PLZT molecules are equivalent to 100 mole% of A-site atoms in PLZT. In addition, the substrate was a heat-resistant laminate substrate having a Pt layer (top layer)/ TiO₂ layer/ SiO₂ layer/ Si base material [crystal orientation plane of the Si base material: (100) plane] structure obtained by depositing a TiO₂ layer and a Pt layer on the surface-oxidized Si base material, that is, a SiO₂ layer on a surface of the Si base material in this order, and Composition 1 was coated on the Pt layer. Furthermore, after the coating step and the drying step were repeated a predetermined number of times, the coated film on the substrate was fired using a rapid thermal annealing (RTA) thermal treatment in an oxygen atmosphere at 700°C (a temperature that is the crystallization temperature of the coated film or higher), and a 180 nm-thick ferroelectric thin film was produced on the substrate. The thin film was used as Example 1.

### <Examples 2 to 4>

Thin films were produced respectively on substrates in the same manner as in Example 1 except that polyvinyl pyrrolidone was added to Composition 1 in an outer percentage of 0.1 mole% (monomer-equivalent) with respect to 100 mole% of the PLZT molecules included in Composition 1, and addition amounts were 10000, 50000 and 100000 in terms of weight average molecular weight. The thin films were used respectively as Examples 2, 3 and 4.

### <Examples 5 to 8>

Thin films were produced respectively on substrates in the same manner as in Example 1 except that polyvinyl pyrrolidone was added to Composition 1 in an outer percentage of 0.3 mole% (monomer-equivalent) with respect to 100 mole% of the PLZT molecules included in Composition 1, and addition amounts were 5000, 10000, 50000 and 100000 in terms of weight average molecular weight. The thin films were used respectively as Examples 5, 6, 7 and 8.

### <Examples 9 to 12>

Thin films were produced respectively on substrates in the same manner as in Example 1 except that polyvinyl pyrrolidone was added to Composition 1 in an outer percentage of 0.5 mole% (monomer-equivalent) with respect to 100 mole% of the PLZT molecules included in Composition 1, and addition amounts were 5000, 10000, 50000 and 100000 in terms of weight average molecular weight. The thin films were used respectively as Examples 9, 10, 11 and 12.

### <Examples 13 to 16>

Thin films were produced respectively on substrates in the same manner as in Example 1 except that polyvinyl pyrrolidone was added to Composition 1 in an outer percentage of 1.0 mole% (monomer-equivalent) with respect to 100 mole% of the PLZT molecules included in Composition 1, and addition amounts were 5000, 10000, 50000 and 100000 in terms of weight average molecular weight. The thin films were used respectively as Examples 13, 14, 15 and 16.

### <Comparative Example 1 >

A thin film was produced on a substrate in the same manner as in Example 1 except that nothing was added to Composition 1. The thin film was used as Comparative Example 1.

### <Comparative Examples 2 to 5>

Thin films were produced respectively on substrates in the same manner as in Example 1 except that polyvinyl pyrrolidone was added to Composition 1 in an outer percentage of 1.5 mole% (monomer-equivalent) with respect to 100 mole% of the PLZT molecules included in Composition 1, and addition amounts were 5000, 10000, 50000 and 100000 in terms of weight average molecular weight. The thin films were used respectively as Comparative Examples 2, 3, 4 and 5.

### <Comparative Examples 6 and 7>

Thin films were produced respectively on substrates in the same manner as in Example 1 except that polyvinyl pyrrolidone was added to Composition 1 in an outer percentage of 0.1 mole% (monomer-equivalent) with respect to 100 mole% of the PLZT molecules included in Composition 1, and addition amounts were 3000 and 200000 in terms of weight average molecular weight. The thin films were used respectively as Comparative Examples 6 and 7.

### <Comparative Examples 8 and 9>

Thin films were produced respectively on substrates in the same manner as in Example 1 except that polyvinyl pyrrolidone was added to Composition 1 in an outer percentage of 0.3 mole% (monomer-equivalent) with respect to 100 mole% of the PLZT molecules included in Composition 1, and addition amounts were 3000 and 200000 in terms of weight average molecular weight. The thin films were used respectively as Comparative Examples 8 and 9.

### <Comparative Examples 10 and 11>

Thin films were produced respectively on substrates in the same manner as in Example 1 except that polyvinyl pyrrolidone was added to Composition 1 in an outer percentage of 0.5 mole% (monomer-equivalent) with respect to 100 mole% of the PLZT molecules included in Composition 1, and addition amounts were 3000 and 200000 in terms of weight average molecular weight. The thin films were used respectively as Comparative Examples 10 and 11.

### <Comparative Examples 12 and 13>

Thin films were produced respectively on substrates in the same manner as in Example 1 except that polyvinyl pyrrolidone was added to Composition 1 in an outer percentage of 1.0 mole% (monomer-equivalent) with respect to 100 mole% of the PLZT molecules included in Composition 1, and addition amounts were 3000 and 200000 in terms of weight average molecular weight. The thin films were used respectively as Comparative Examples 12 and 13.

### <Comparative Examples 14 and 15>

Thin films were produced respectively on substrates in the same manner as in Example 1 except that polyvinyl pyrrolidone was added to Composition 1 in an outer percentage of 1.5 mole% (monomer-equivalent) with respect to 100 mole% of the PLZT molecules included in Composition 1, and addition amounts were 3000 and 200000 in terms of weight average molecular weight. The thin films were used respectively as Comparative Examples 14 and 15.

### <Comparison Test 1 and Evaluation>

Electrostatic capacitances and relative permittivity of the thin films of Examples 1 to 16 and Comparative Examples 1 to 15 were respectively measured. Specifically, a Pt top electrode having an approximately 250 µm×250 µm-square shape was produced on the substrate on which the obtained ferroelectric thin film had been formed using a metal mask and a sputtering method, and the C-V characteristics (reliance of electrostatic capacitance on voltage) between the Pt top electrode and a Pt bottom electrode immediately below the ferroelectric thin film were evaluated in a range of -5 V to 5 V at a frequency of 1 kHz. In addition, a relative permittivity was computed from the maximum value of measured electrostatic capacitances. Meanwhile, a precision LCR meter (manufactured by Hewlett Packard Development Company, precision LCR meter 4284A) was used in the measurement of the C-V characteristics. In addition, as measurement conditions, a bias step was set to 0.1 V, a frequency of a voltage was set to 1 kHz, an oscillation level of the voltage was set to 30 mV, a delay time was set to 0.2 seconds, a temperature was set to 23°C, and a humidity was set to 50±10%. The results are described in Table 1. Meanwhile, Table 1 respectively describes the electrostatic capacitances and relative permittivity of the thin films, ratios of Pb/La/Zr/Ti in Composition 1, the molecular weights and addition amounts of the stabilizing agent added to Composition 1 and the polyvinyl pyrrolidone (PVP) added to Composition 1 and firing atmospheres of the thin films.

**[Table 1]**

| | Pb/La/Zr/Ti | Polyvinyl pyrrolidone (PVP) | | Firing atmosphere | Electrostatic capacitance | Relative permittivity |
|---|---|---|---|---|---|---|
| | | Molecular weight | Addition amount (mole%) | | (µF/cm²) | |
| Example 1 | 125/3/52/48 | 5000 | 0.1 | Oxygen | 8.50 | 1920 |
| Example 2 | Same as above | 10000 | 0.1 | Same as above | 8.50 | 1920 |
| Example 3 | Same as above | 50000 | 0.1 | Same as above | 8.59 | 1940 |
| Example 4 | Same as above | 100000 | 0.1 | Same as above | 8.59 | 1940 |
| Example 5 | Same as above | 5000 | 0.3 | Same as above | 8.59 | 1940 |
| Example 6 | Same as above | 10000 | 0.3 | Same as above | 8.59 | 1940 |
| Example 7 | Same as above | 50000 | 0.3 | Same as above | 8.59 | 1940 |
| Example 8 | Same as above | 100000 | 0.3 | Same as above | 8.59 | 1940 |
| Example 9 | Same as above | 5000 | 0.5 | Same as above | 8.59 | 1940 |
| Example 10 | Same as above | 10000 | 0.5 | Same as above | 8.59 | 1940 |
| Example 11 | Same as above | 50000 | 0.5 | Same as above | 8.59 | 1940 |
| Example 12 | Same as above | 100000 | 0.5 | Same as above | 8.59 | 1940 |
| Example 13 | Same as above | 5000 | 1.0 | Same as above | 8.59 | 1940 |
| Example 14 | Same as above | 10000 | 1.0 | Same as above | 8.59 | 1940 |
| Example 15 | Same as above | 50000 | 1.0 | Same as above | 8.59 | 1940 |
| Example 16 | Same as above | 100000 | 1.0 | Same as above | 8.59 | 1940 |
| Comparative Example 1 | Same as above | - | - | Same as above | 8.59 | 1940 |
| Comparative Example 2 | Same as above | 5000 | 1.5 | Same as above | 8.59 | 1940 |
| Comparative Example 3 | Same as above | 10000 | 1.5 | Same as above | 8.59 | 1940 |
| Comparative Example 4 | Same as above | 50000 | 1.5 | Same as above | 8.59 | 1940 |
| Comparative Example 5 | Same as above | 100000 | 1.5 | Same as above | 8.59 | 1940 |
| Comparative Example 6 | Same as above | 3000 | 0.1 | Same as above | 8.59 | 1940 |
| Comparative Example 7 | Same as above | 200000 | 0.1 | Same as above | 8.59 | 1940 |
| Comparative Example 8 | Same as above | 3000 | 0.3 | Same as above | 8.59 | 1940 |
| Comparative Example 9 | Same as above | 200000 | 0.3 | Same as above | 8.59 | 1940 |
| Comparative Example 10 | Same as above | 3000 | 0.5 | Same as above | 8.59 | 1940 |
| Comparative Example 11 | Same as above | 200000 | 0.5 | Same as above | 8.59 | 1940 |
| Comparative Example 12 | Same as above | 3000 | 1.0 | Same as above | 8.59 | 1940 |
| Comparative Example 13 | Same as above | 200000 | 1.0 | Same as above | 8.59 | 1940 |
| Comparative Example 14 | Same as above | 3000 | 1.5 | Same as above | 8.59 | 1940 |
| Comparative Example 15 | Same as above | 200000 | 1.5 | Same as above | 8.59 | 1940 |

As is evident from Table 1, it was found that, while the electrostatic capacitance and relative permittivity were as low as 8.10 µF/cm² and 1830 respectively in the thin film of Comparative Example 1 to which PVP had not been added, and the electrostatic capacitance and relative permittivity were as low as 7.44 µF/cm² to 7.53 µF/cm² and 1680 to 1700 respectively in the thin films of Comparative Examples 2 to 5 in which the addition amount of PVP had been as excessively large as 1.5 mole% (molar ratio=PVP/PLZT molecules=1.5/100=0.015), the electrostatic capacitance and relative permittivity increased to be 8.50 µF/cm² to 9.61 µF/cm² and 1920 to 2170 respectively in the thin films of Examples 1 to 16 in which the addition amount of PVP had been in an appropriate range of 0.1 mole% to 1.0 mole% (molar ratio=PVP/PLZT molecules=(0.1 to 1.0)/100=0.001 to 0.01). In addition, it was found that, while the electrostatic capacitance and relative permittivity were as low as 7.92 µF/cm² to 8.06 µF/cm² and 1790 to 1820 respectively in the thin films of Comparative Examples 6, 8, 10, 12 and 14 in which the molecular weight of PVP had been as excessively small as 3000, and the electrostatic capacitance and relative permittivity were as low as 7.35 µF/cm² to 7.79 µF/cm² and 1660 to 1760 respectively in the thin films of Comparative Examples 7, 9, 11, 13 and 15 in which the molecular weight of PVP had been as excessively large as 200000, the electrostatic capacitance and relative permittivity increased to be 8.50 µF/cm² to 9.61 µF/cm² and 1920 to 2170 respectively in the thin films of Examples 1 to 16 in which the molecular weight of PVP had been in an appropriate range of 5000 to 100000.

### <Example 17>

First, Zr tetra n-butoxide (Zr source), Ti isopropoxide (Ti source) and lactic acid (stabilizing agent) were put into a reaction container, and refluxed in a nitrogen atmosphere. Next, lead acetate trihydrate (Pb source) was added to the compound, propylene alcohol (solvent) was added, the components were refluxed in a nitrogen atmosphere, distilled under reduced pressure so as to remove byproducts, and then a diluted alcohol was added to the solution, thereby obtaining Composition 2 containing a concentration of 10 mass% of metal compounds in terms of an oxide in which a ratio of respective metals (Pb/La/Zr/Ti) became 125/0/52/48. Here, a mixing fraction of the lactic acid (stabilizing agent) is 2 mole in 1 mole of a total amount of metals in the composition. Polyvinyl pyrrolidone (weight average molecular weight: 10000) was added to Composition 2 in an outer percentage of 0.3 mole% (monomer-equivalent) with respect to 100 mole% of PLZT molecules included in Composition 2, furthermore, particles of byproducts were removed, Composition 2 was coated on a substrate using a spin coating method so as to form a coated film, and then the coated film on the substrate was heated at 350°C (a temperature lower than the crystallization temperature of the coated film) in the air so as to be dried. Here, 100 mole% of the PZT molecules are equivalent to 100 mole% of the A-site atoms in PZT. In addition, the substrate was a heat-resistant laminate substrate having a Pt layer (top layer)/ TiO₂ layer/ SiO₂ layer/ Si base material [crystal orientation plane of the Si base material: (100) plane] structure obtained by depositing a TiO₂ layer and a Pt layer on the surface-oxidized Si base material, that is, a SiO₂ layer on a surface of the Si base material in this order, and Composition 3 was coated on the Pt layer. Furthermore, after the coating step and the drying step were repeated a predetermined number of times, the coated film on the substrate was fired using a rapid thermal annealing (RTA) thermal treatment in an oxygen atmosphere at 700°C (a temperature that is the crystallization temperature of the coated film or higher); and a 180 nm-thick ferroelectric thin film was produced on the substrate. The thin film was used as Example 17.

### <Example 18>

First, Ti isopropoxide (Ti source) and lactic acid (stabilizing agent) were put into a reaction container, and refluxed in a nitrogen atmosphere. Next, lead acetate trihydrate (Pb source) was added to the compound, propylene alcohol (solvent) was added, the components were refluxed in a nitrogen atmosphere, distilled under reduced pressure so as to remove byproducts, and then a diluted alcohol was added to the solution, thereby obtaining Composition 3 containing a concentration of 10 mass% of metal compounds in terms of an oxide in which a ratio of respective metals (Pb/La/Zr/Ti) became 125/0/0/100. Here, a mixing fraction of the lactic acid (stabilizing agent) is 2 mole in 1 mole of a total amount of metals in the composition. Polyvinyl pyrrolidone (weight average molecular weight: 10000) was added to Composition 3 in an outer percentage of 0.3 mole% (monomer-equivalent) with respect to 100 mole% of PLZT molecules included in Composition 3, furthermore, particles of byproducts were removed, Composition 3 was coated on a substrate using a spin coating method so as to form a coated film, and then the coated film on the substrate was heated at 350°C (a temperature lower than the crystallization temperature of the coated film) in the air so as to be dried. Here, 100 mole% of the PZT molecules are equivalent to 100 mole% of the A-site atoms in PZT. In addition, the substrate was a heat-resistant laminate substrate having a Pt layer (top layer)/ TiO₂ layer/ SiO₂ layer/ Si base material [crystal orientation plane of the Si base material: (100) plane] structure obtained by depositing a TiO₂ layer and a Pt layer on the surface-oxidized Si base material, that is, a SiO₂ layer on a surface of the Si base material in this order, and Composition 3 was coated on the Pt layer. Furthermore, after the coating step and the drying step were repeated a predetermined number of times, the coated film on the substrate was fired using a rapid thermal annealing (RTA) thermal treatment in an oxygen atmosphere at 700°C (a temperature that is the crystallization temperature of the coated film or higher), and a 180 nm-thick ferroelectric thin film was produced on the substrate. The thin film was used as Example 18.

**[Table 2]**

| | Pb/La/Zr/Ti | Polyvinyl pyrrolidone (PVP) | | Firing atmosphere | Electrostatic capacitance | Relative permittivity |
|---|---|---|---|---|---|---|
| | | Molecular weight | Addition amount (mole%) | | (µF/cm²) | |
| Example 17 | 125/0/52/48 | 10000 | 0.3 | Oxygen | 8.94 | 2020 |
| Example 18 | 125/0/0/100 | 10000 | 0.3 | Same as above | 0.84 | 190 |

As is evident from Table 2, both Examples 17 and 18 exhibited preferable electrostatic capacitances and relative permittivity.

### [Industrial Applicability]

The composition for forming ferroelectric thin films of the invention, the method for forming thin films and the thin film formed using the method can be used in thin film capacitors having a high capacitance and a high density. Also, in addition to the thin film capacitors, the composition for forming ferroelectric thin films of the invention, the method for forming thin films and the thin film formed using the method can be used in complex electronic components such as IPDs, DRAM memory capacitors, multi-layer capacitors, gate insulators of transistors, non-volatile memories, pyroelectric infrared detection elements, piezoelectric elements, electrooptic elements, actuators, resonators, ultrasonic motors, surface acoustic wave elements, transducers and LC noise filter elements.

## Claims

1. A composition for forming ferroelectric thin films which is to form ferroelectric thin films made of a titanate lead-based perovskite film or a titanate zirconate lead-based complex perovskite film, comprising:
lead acetate;
a stabilizing agent made of lactic acid; and
polyvinyl pyrrolidone,
wherein a monomer-equivalent molar ratio of polyvinyl pyrrolidone to a perovskite A site atom included in the composition is more than 0 to less than 0.015, and
a weight average molecular weight of the polyvinyl pyrrolidone is 5000 to 100000.

2. The composition for forming ferroelectric thin films according to Claim 1,
wherein the titanate lead-based perovskite film or the titanate zirconate lead-based complex perovskite film is represented by a formula [(PbₓLa_{y})(Zr_{z}Ti_{(1-z)})O₃].
In the formula, 0.9<x<1.3, 0≤y<0.1, 0≤z<0.9.

3. The composition for forming ferroelectric thin films according to Claim 1,
wherein a raw material for configuring the titanate lead-based perovskite film or the titanate zirconate lead-based complex perovskite film is a compound in which an organic group is bonded with a metal element through an oxygen atom or a nitrogen atom.

4. The composition for forming ferroelectric thin films according to Claim 3,
wherein the raw material for configuring the titanate lead-based perovskite film or the titanate zirconate lead-based complex perovskite film is one or two or more selected from a group consisting of organic acid salts, metal alkoxides, metal β-diketonate complexes, metal β-diketone ester complexes, metal β-iminoketo complexes and metal amino complexes.

5. The composition for forming ferroelectric thin films according to any one of Claims 1 to 4,
wherein the stabilizing agent is further included in a fraction of 0.2 mole to 3 mole in 1 mole of a total amount of metals in the composition.

6. The composition for forming ferroelectric thin films according to Claim 1,
wherein the monomer-equivalent molar ratio of polyvinyl pyrrolidone to the perovskite A site atom included in the composition is 0.001 to 0.01.

7. A method for forming ferroelectric thin films comprising:
a coating step in which the composition for forming ferroelectric thin films according to any one of Claims 1 to 6 is coated on a substrate so as to form a coated film;
a drying step in which the coated film formed on the substrate is heated in air, an oxidizing atmosphere or a water vapor-containing atmosphere so as to be dried; and
a firing step in which the coated film is fired at a crystallization temperature or higher in O₂, N₂, Ar, N₂O, H₂, a gas mixture thereof, dried air or the above atmosphere including water vapor from middle of or after completion of the drying step.

8. A method for forming ferroelectric thin films comprising:
a coating step in which the composition for forming ferroelectric thin films according to any one of Claims 1 to 6 is coated on a substrate so as to form a coated film;
a drying step in which the coated film formed on the substrate is heated in air, an oxidizing atmosphere or a water vapor-containing atmosphere so as to be dried;
a repeating step in which the coating step and the drying step are repeated plural times; and
a firing step in which the coated film is fired at a crystallization temperature or higher in O₂, N₂, Ar, N₂O, H₂, a gas mixture thereof, dried air or the above atmosphere including water vapor from middle of or after completion of a final drying step in the repeating step.

9. A ferroelectric thin film formed using the method according to Claim 7 or 8.

10. A complex electronic component made up of any of thin film capacitors, capacitors, IPDs, DRAM memory capacitors, multi-layer capacitors, gate insulators of transistors, non-volatile memories, pyroelectric infrared detection elements, piezoelectric elements, electrooptic elements, actuators, resonators, ultrasonic motors, surface acoustic wave elements, transducers and LC noise filter elements which have the ferroelectric thin film according to Claim 9.

11. A complex electronic component made up of any of thin film capacitors, capacitors, IPDs, DRAM memory capacitors, multi-layer capacitors, gate insulators of transistors, non-volatile memories, pyroelectric infrared detection elements, piezoelectric elements, electrooptic elements, actuators, resonators, ultrasonic motors, surface acoustic wave elements, transducers and LC noise filter elements which have a ferroelectric thin film that is the ferroelectric thin film according to Claim 9 and corresponds to a frequency band of 100 MHz or more.
